# EUROPEAN PATENT APPLICATION

(11) **EP 4 739 081 A2**
(43) Date of publication of application: **06.05.2026**
(21) Application number: 25210334.6
(22) Date of filing: 22.10.2025
(51) Int. Cl.: H10W 74/01, H10W 74/10, H10W 90/10, H10W 70/40, H10W 70/04

(54) **METHOD FOR MANUFACTURING A SYSTEM IN PACKAGE (SIP) USING AN INTEGRATED PACKLET ON LEADFRAME**

(30) Priority: 29.10.2024 US 202463713336 P; 06.10.2025 US 202519350574
(71) Applicant: STMicroelectronics International N.V., 1228 Plan-les-Ouates, Geneva (CH)
(72) Inventor: RENARD, Loic Pierre Louis, 329682 Singapore (SG)
(74) Representative: Casalonga

(57) **Abstract**

A system in package (SiP) includes two or more integrated circuit (IC) packlets performing different functionalities. Each packlet includes a bare functional IC die encapsulated within a first body and including etched individual leads. The packlets are mounted to a leadframe and encapsulated within a second body. A metal heatsink is attached to the leadframe, on a side opposite the two or more IC packlets, using a non-electrically conductive adhesive material.

## Description

### CROSS REFERENCE TO RELATED APPLICATIONS

This application claims priority to United States Provisional Application for Patent No. 63/713,336, filed October 29, 2024, the content of which is incorporated herein by reference.

### TECHNICAL FIELD

The present invention generally relates to integrated circuit packaging and, more particularly, to a system in package (SiP) where two or more integrated circuit dies are supported by an electrical interconnection structure and encapsulated within a package body.

### BACKGROUND

A system in package (SiP) is a single package that contains multiple integrated circuits (ICs) interconnected with each other to perform the functions of an entire system. The included electronics within a given SiP may comprise: a power IC, a processing IC, a memory IC, a communication IC, and specific functional ICs. SiPs are used to simplify the design of complex electronic systems by combining all the necessary components of the system within a single package body. SiPs are ideal solutions when the system has an advanced design and the application has space constraints.

SiP testing and verification can be a challenge to implement. There is typically a high level of integration and complexity in the design, and with the use of multiple IC dies there can be concerns with yield.

The conventional process for making a SiP is to mount the ICs dies on a leadframe, a direct copper bond (DCB) on ceramic substrate or an active metal brazed (AMB) on ceramic substrate.

### SUMMARY

In an embodiment, a method comprises: mounting a plurality of bare integrated circuit (IC) dies rear face down to a metal plate; connecting electrical interconnections between connection pads at front faces of the plurality of bare IC dies and connection regions of the metal plate; placing the metal plate with the plurality of bare IC dies and electrical interconnections in a first mold cavity; injecting an encapsulation material into the first mold cavity to encapsulate the plurality of bare IC dies and electrical interconnections within a first encapsulating body and form a panel; etching the metal plate to form individual metal leads at the connection regions; and cutting through the first encapsulating body at locations between adjacent IC dies to singulate the panel into a plurality of packlets.

In an embodiment, the plurality of bare IC dies are configured to perform a same functionality, and the processing described above is repeated with bare IC dies having different functionalities to produce packlets having different functionalities.

In an embodiment, a method comprises: mounting a group of packlets to a carrier tape, wherein said group of packlets includes a packlet having a first functionality and a packlet having a second functionality; placing the carrier tape with the group of packlets in a second mold cavity; injecting an encapsulation material into the second mold cavity to encapsulate the group of packlets within a second encapsulating body to form an encapsulated packlet group; removing the carrier tape; attaching the encapsulated packlet group to a leadframe, wherein the individual metal leads of the packlets having the first and second functionalities of the encapsulated packlet group are mounted to corresponding leadframe leads of the leadframe; and mounting a heatsink using a non-electrically conductive adhesive material to the leadframe opposite the group of packlets to form a system in package (SiP).

In an embodiment, a method comprises: mounting a group of packlets to a leadframe, wherein the group of packlets includes a packlet having a first functionality and a packlet having a second functionality connected to a plurality of leadframe leads of the leadframe; mounting a heatsink using a non-electrically conductive adhesive material to the leadframe opposite the group of packlets; placing the leadframe with the group of packlets and the adhesively mounted heatsink in a second mold cavity; and injecting an encapsulation material into the second mold cavity to encapsulate the group of packlets and adhesively mounted heatsink within a second encapsulating body to form a system in package (SiP).

In an embodiment, a method comprises: mounting a plurality of groups of packlets to a carrier tape; wherein each group of packlets includes a first functionality packlet and a second functionality packet; wherein each first functionality packlet comprises a first bare integrated circuit (IC) die encapsulated within a first encapsulating body and including etched individual metal leads; wherein each second functionality packlet comprises a second bare IC die encapsulated within a second encapsulating body and including etched individual metal leads; placing the carrier tape with the groups of packlets in a mold cavity; injecting an encapsulation material into the mold cavity to encapsulate the groups of packlets within a third encapsulating body; cutting through the third encapsulating body between adjacent groups of packlets in a singulation operation to form a corresponding plurality of individual encapsulated packlet groups; removing the carrier tape; attaching the plurality of individual encapsulated packlet groups to a leadframe, wherein the etched individual metal leads of the first and second functionality packlets of each individual encapsulated packlet group are mounted to corresponding leadframe leads of the leadframe; and mounting a heatsink using a non-electrically conductive adhesive material to the leadframe at each individual encapsulated packlet group, wherein each individual encapsulated packlet group, with leadframe leads and adhesively mounted heatsink forms a system in package (SiP).

In an embodiment, a method comprises: mounting a plurality of groups of packlets to a leadframe; wherein each group of packlets includes a first functionality packlet and a second functionality packet; wherein each first functionality packlet comprises a first bare integrated circuit (IC) die encapsulated within a first encapsulating body and including etched individual metal leads; wherein each second functionality packlet comprises a second bare IC die encapsulated within a second encapsulating body and including etched individual metal leads; mounting a heatsink using a non-electrically conductive adhesive material to the leadframe opposite each group of packlets; placing the leadframe with the groups of packlets and the adhesively mounted heatsinks in a mold cavity; injecting an encapsulation material into the mold cavity to encapsulate each group of packlets and adhesively mounted heatsink within a third encapsulating body, wherein the third encapsulating body with an individual encapsulated packlet group, leadframe leads and adhesively mounted heatsink forms a system in package (SiP).

### BRIEF DESCRIPTION OF THE DRAWINGS

For a better understanding of the embodiments, reference will now be made by way of example only to the accompanying figures in which:
Figures 1A-1K show steps in a process for manufacturing an integrated circuit (IC) packlet;
Figure 2A-2E which show bottom views of IC packlets produced using the process of Figures 1A-1K;
Figures 3A-3J show steps in a process for manufacturing a system in package (SiP) which includes a plurality of IC packlets;
Figure 4 shows a bottom view with a SiP leadframe mounted to an encapsulated packlet group;
Figures 5A-5G show steps in a process for manufacturing a system in package (SiP) which includes a plurality of IC packlets; and
Figure 6 shows a bottom view with a SiP leadframe mounted to which a plurality of IC packlets are attached.

### DETAILED DESCRIPTION

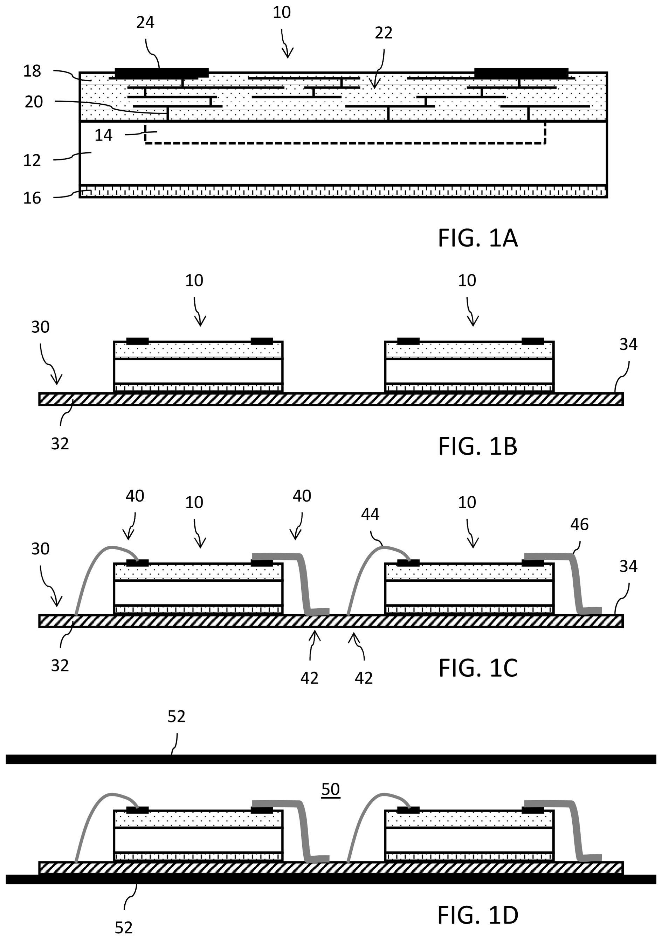

Reference is now made to Figures 1A-1K which show steps in a process for manufacturing an integrated circuit (IC) packlet.

Figure 1A - bare integrated circuit dies 10 are formed using conventional front end of line (FEOL), middle end of line (MEOL) and back end of line (BEOL) processing techniques well known to those skilled in the art of manufacturing integrated circuits. One such bare integrated circuit die 10 is shown (in cross-section) in Figure 1A, but it is well understood that the semiconductor manufacturing process can produce many such dies from the dicing (singulation) of a single integrated circuit processing wafer. As is known: FEOL refers to the phase of semiconductor manufacturing process where the active parts of the integrated circuit (such as transistors, diodes, resistors, capacitors, etc.) are formed; MEOL refers to the phase of semiconductor manufacturing process where structures providing pathways or contacts between structures of the FEOL and BEOL are formed; and BEOL refers to the phase of semiconductor manufacturing process where metal interconnects in multiple interconnect levels are formed to enable electrical interconnection of the integrated circuits formed in the FEOL. Each bare integrated circuit die 10 includes a semiconductor layer 12 within and on which are formed, in the FEOL phase, integrated circuitry 14. A back surface of the semiconductor layer 12 is covered by an insulating layer 16. A front surface of the semiconductor layer 12 is covered by an interconnection layer 18 within which are formed, in the MEOL an BEOL phases, the structures for accessing the integrated circuitry 14 (using, for example, electrical contacts 20), electrically interconnecting integrated circuitry 14 (using, for example, metallization layers 22 with metal lines and vias), and providing external electrical access (using, for example, electrical connection pads 24).

The bare integrated circuit die 10 can be designed with interconnected integrated circuitry 14 to provide any of the individual IC functions which are needed for the SiP. For example, the die 10 can be a power IC, a processing IC, a memory IC, a communication IC, or a specific functional IC.

Figure 1B - a plurality of bare integrated circuit dies 10 (for example, all made to provide the same IC function) are mounted (at the side of the insulating layer 16) to surface 30 of a metal plate 32. The metal plate 32 may, for example, be made of copper. The surface 30 of the metal plate 32 may, for example, be plated with a layer 34 of silver (Ag) or nickel-palladium-gold alloy (NiPdAu).

Figure 1C - electrical interconnections 40 are then formed between the electrical connection pads 22 of the plurality of bare integrated circuit dies 10 and the surface 30 of the metal plate 32 at connection regions 42. The electrical interconnections 40 may, for example, comprise wirebonds 44 and/or metal clips 46.

Figure 1D - the metal plate 32 with the mounted and electrically connected bare integrated circuit dies 10 is then placed with a cavity 50 of a two-part mold 52.

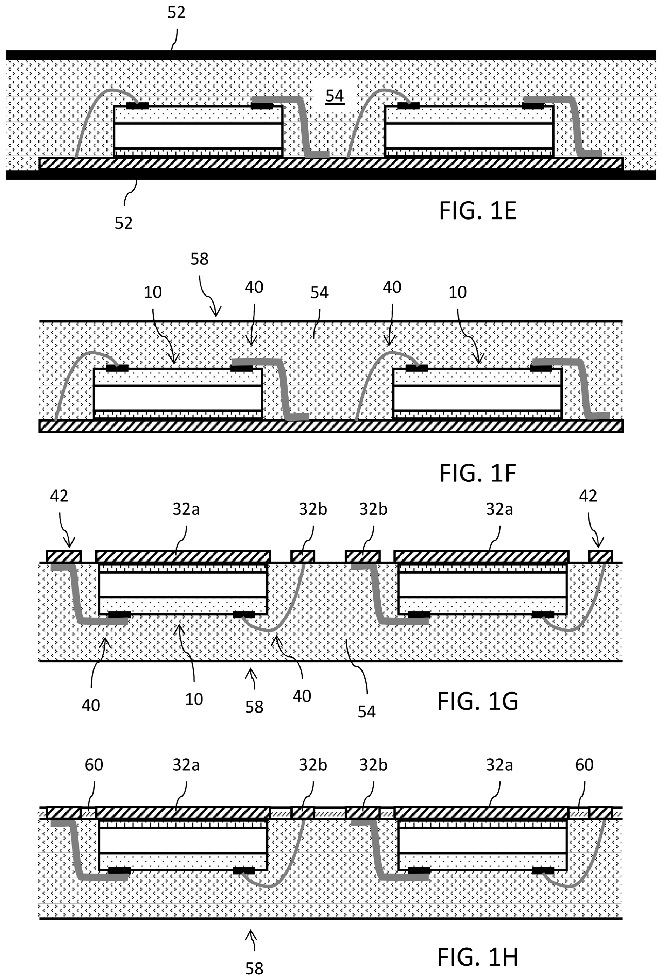

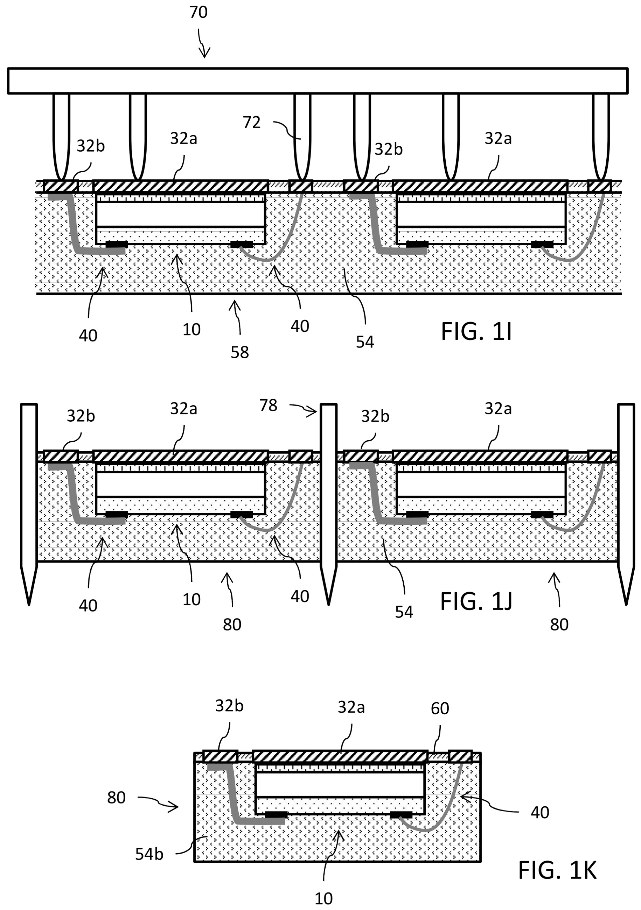

Figure 1E - an encapsulation material 54 is injected into the cavity 50 and allowed to cure so as to laterally encapsulate each of the bare integrated circuit dies 10 as well as the electrical interconnections 40. This encapsulation material 54 provides an encapsulating body 54b of each IC packlet 80 (see, Figure 1K).

Figure 1F - the encapsulated bare integrated circuit dies 10 mounted to the plate 32 are removed from the mold 56 to form a first panel structure 58.

Figure 1G - using conventional etch process techniques (for example: resist deposition, resist patterning to form an etch mask, copper etching, and resist strip), the metal plate 32 of the panel structure 58 is etched to form metal die pads 32a at the location of the bare integrated circuit dies 10 and metal leads 32b at the connection regions 42 for the electrical interconnections 40.

Figure 1H - an optional molding process may then be performed to provide an insulating fill layer 60 on the surface of the encapsulation material 54 between the metal die pads 32a and metal leads 32b.

Figure 1I -the bare integrated circuit dies 10 encapsulated within the panel structure 58 can be tested using a testing probe tool 70 to ensure that the electrical interconnections 40 and the formation of the metal die pads 32a and metal leads 32b were properly made and that the included bare integrated circuit dies 10 are functioning properly. Probes 72 of the tool 70 are placed in contact with the metal die pads 32a and metal leads 32b and electrical signals (power, ground, test patterns, etc.) are applied to the encapsulated bare integrated circuit dies 10 to ensure proper operation.

The encapsulated bare integrated circuit dies 10 of the panel structure 58 which fail testing are noted by the testing probe tool 70.

Figure 1J - following testing, the panel structure 58 is then processed in a singulation operation by cutting 78 (for example, dicing) the panel into a plurality of individual packlets 80 (one such packlet 80 is shown in Figure 1K). The cutting may be performed by a sawing action taken along scribe line locations of the panel structure 58 between the locations of the encapsulated bare integrated circuit dies 10.

The singulated packlets 80 which include a noted encapsulated bare integrated circuit die 10 that failed testing are discarded. Non-defective singulated packlets 80 are retained for use as components in the manufacture of SiPs.

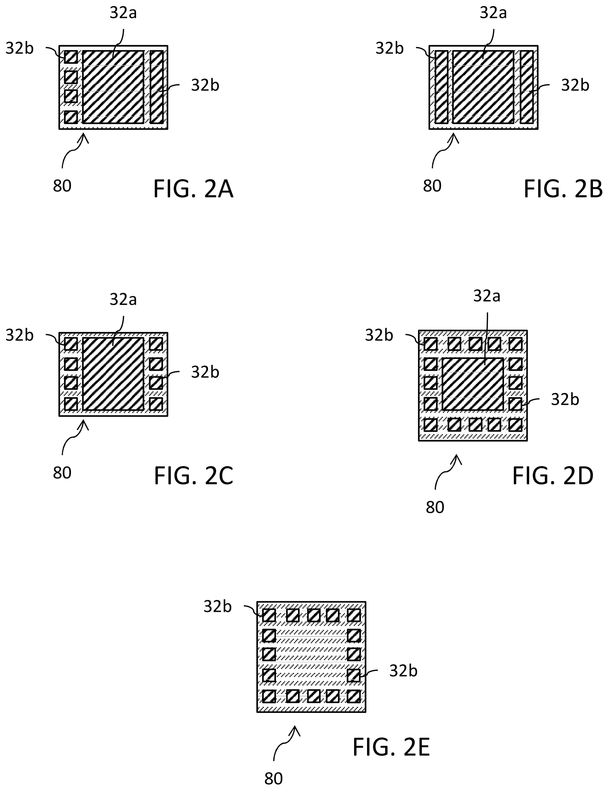

Reference is now made to Figure 2A-2E which show bottom views of a variety of packlets 80 produced using the process of Figures 1A-1J having different layouts for the metal die pads 32a and metal leads 32b which are suited to the type of bare integrated circuit die 10 which could be used in a system in package (SiP). It will be noted, with reference to Figure 2E, that in some integrated circuits there will not be a need for a metal die pad 32a. It will also be noted, that the number, arrangement, and size of the metal leads 32b for the packlet 80 may vary depending on the bare integrated circuit die 10 included within each packlet 80.

An advantage of the use of packlets 80 is that testing is completed before the integrated circuit dies 10 are used in the manufacture of the SiP. This allows for a higher yield with respect to SiP manufacture.

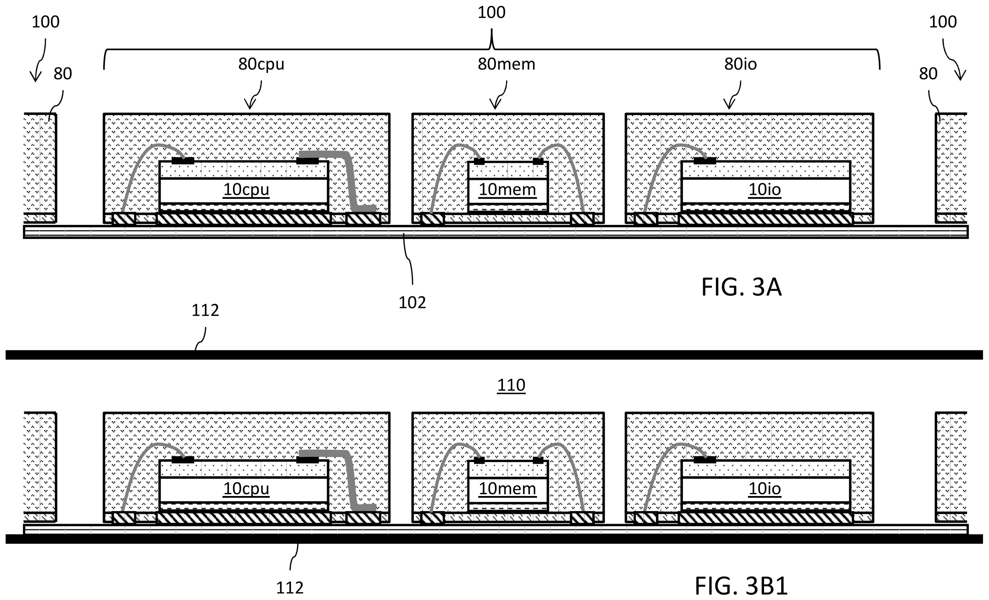

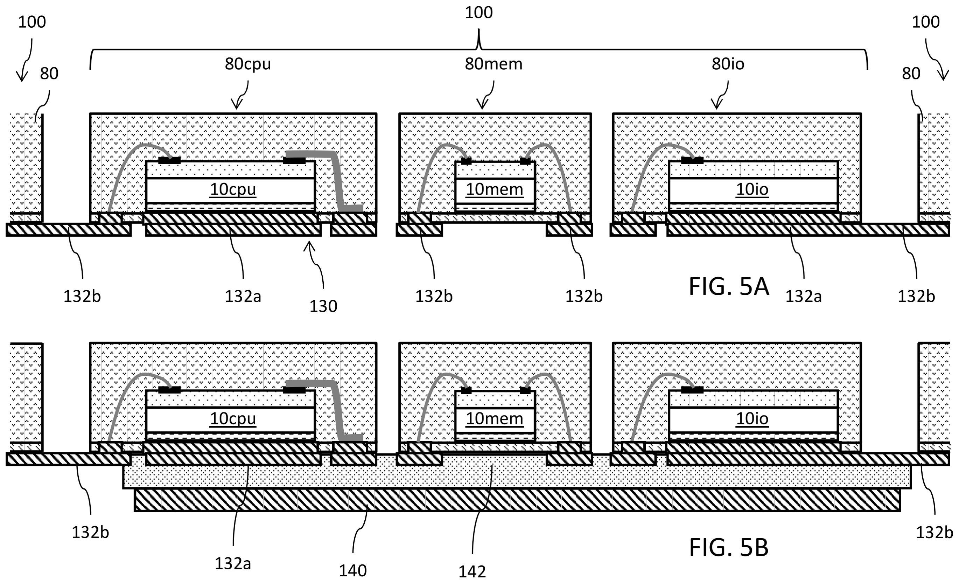

An additional advantage of the use of packlets 80 is that they are more robust than the bare integrated circuit die 10. Because of this, alternative interconnections for the SiP can be used (see, for example, the manufacturing processes of Figures 3A-3J and 5A-5G discussed herein.

Reference is now made to Figures 3A-3J which show steps in a process for manufacturing a system in package (SiP) which includes a plurality of IC packlets 80. The packlets 80 may be made using the process of Figures 1A-1K. The IC packlets 80 to be included in the SiP perform different functionalities. For example, the SiP may include: an IC packlet 80cpu which includes an encapsulated bare integrated circuit die 10cpu configured to perform processing functionalities; an IC packlet 80mem which includes an encapsulated bare integrated circuit die 10mem configured to perform data storage (memory) functionalities; and an IC packlet 80io which includes an encapsulated bare integrated circuit die 10io configured to perform communication (input/output) functionalities. It will be understood that the illustrated inclusion of packlets 80 for processing, memory and communication functionalities is just an example, without limitation, of what may be included in the SiP.

Figure 3A - a plurality of groups 100 of IC packlets 80 for each SiP are mounted adjacent each other on a carrier tape 102. The illustration of this figure shows all the packlets 80 of one group 100 as well as a portion of a packlet 80 within each of the groups 100 adjacent (to the left and right) thereto. It will be understood that more than three groups 100 may be mounted to the carrier tape 102 for common processing. As an example, each of the groups 100 includes the IC packlets 80cpu, 80mem, 80io for the SiP.

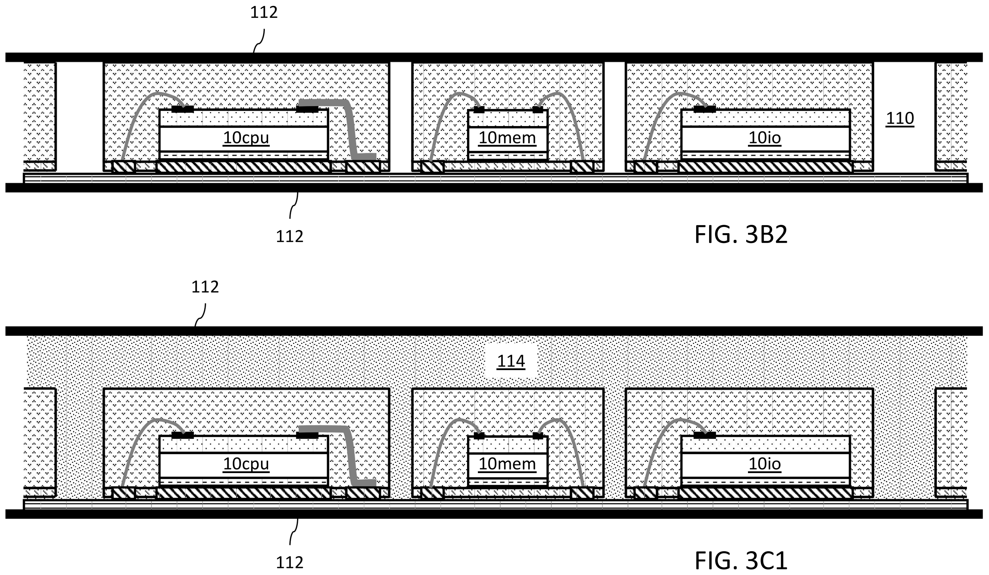

Figures 3B1, 3B2 - the carrier tape 102 with the mounted groups 100 of IC packlets 80 is then placed with a cavity 110 of a two-part mold 112. The two-part mold 112 of Figure 3B1 differs from the two-part mold 112 of Figure 3B2 only in terms of the size of the cavity 110. In Figure 3B1, the two-part mold 112 defines a cavity 110 with a depth larger than a thickness of the IC packlets 80 mounted to the carrier tape 102. In Figure 3B2, the two-part mold 112 defines a cavity 110 with a depth equal to a thickness of the IC packlets 80 mounted to the carrier tape 102.

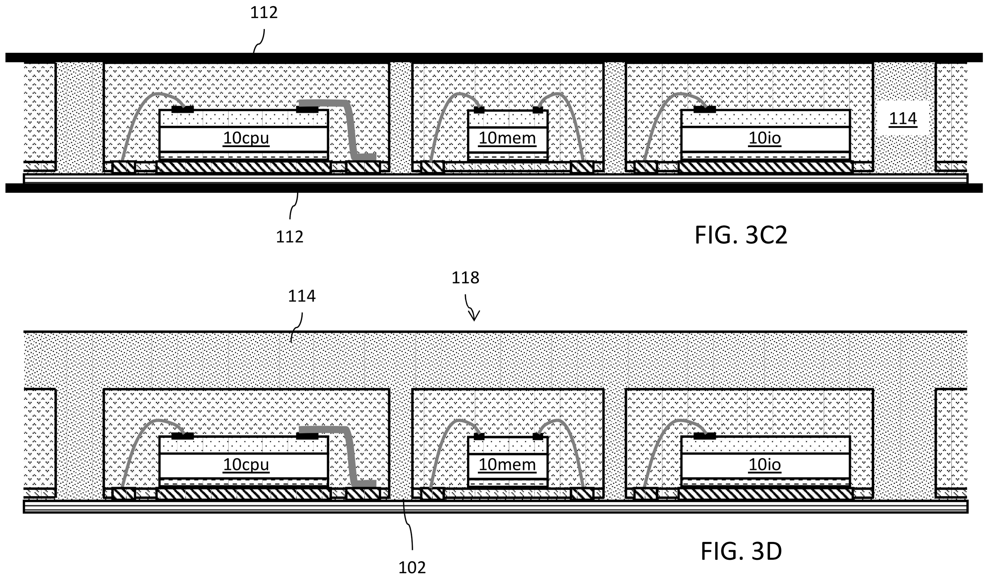

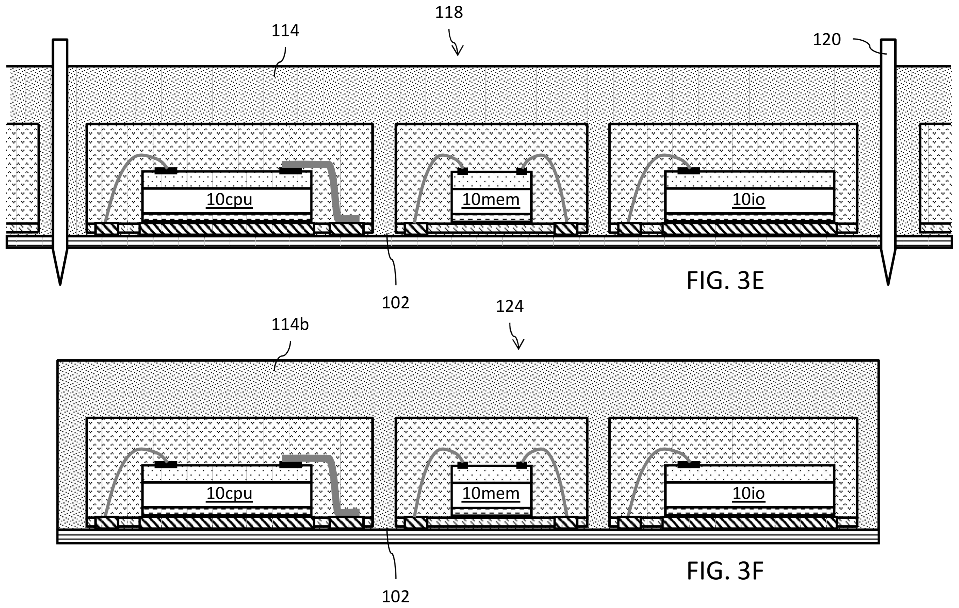

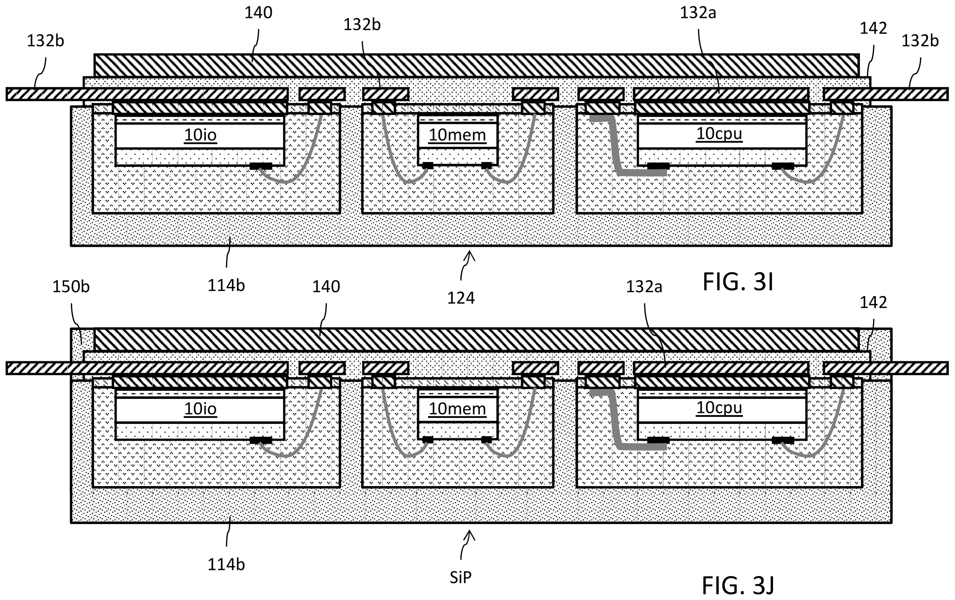

Figures 3C1, 3C2 - an encapsulation material 114 is injected into the cavity 110 and allowed to cure so as to laterally encapsulate each of the groups 100 of IC packlets 80. This encapsulation material 114 provides an encapsulating body 114b (Figures 3F and 3J) of each SiP (Figure 3J).

Figure 3D - the encapsulated groups 100 of IC packlets 80 mounted to the carrier tape 102 are removed from the mold 112 to form a second panel structure 118. It will be noted here that the illustration shows the second panel structure 118 produced by the molding operations of Figures 3B1 and 3C1 where portions of the encapsulation material 114 cover the upper surfaces of the included IC packlets 80. The second panel structure 118 produced by the molding operations of Figures 3B2 and 3C2 would look the same except that the upper surface of the encapsulation material 114 would be coplanar with the upper surfaces of the included IC packlets 80. The remainder of the description for the process of manufacturing the SiP will refer to the second panel structure 118 as shown in Figure 3D, but it will be understood that the steps in the process are equally applicable to second panel structure 118 produced by the molding operations of Figures 3B2 and 3C2.

Figure 3E - the panel structure 118 is then processed in a singulation operation by cutting 120 (for example, dicing) the panel into a plurality of individual encapsulated packlet groups 124 (one such encapsulated packlet group 124 shown in Figure 3F). The cutting may be performed by a sawing action taken along scribe line locations between the locations of the groups 100.

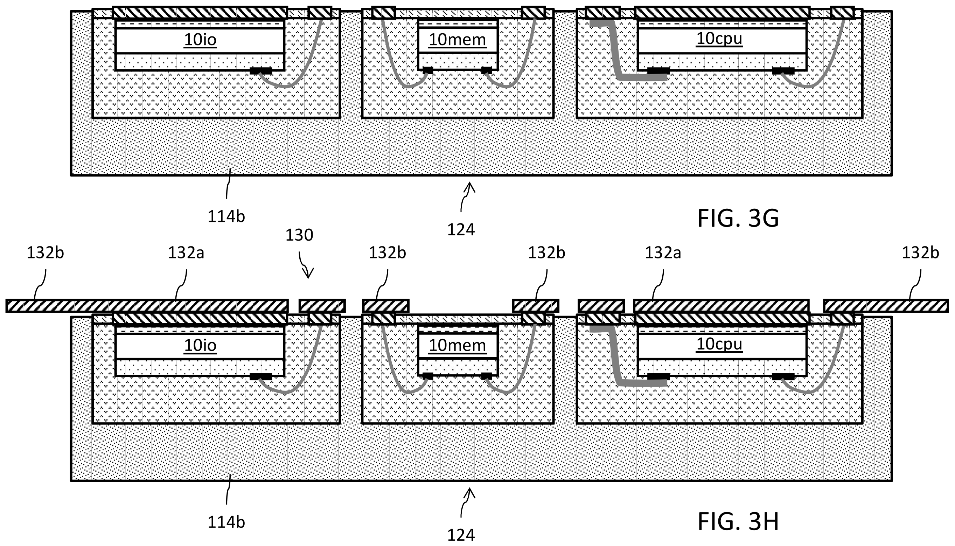

Figure 3G - the remaining carrier tape 102 is removed from the encapsulated packlet group 124 to expose the metal die pads 32a (if present) and metal leads 32b of the IC packlets 80 within the encapsulated packlet group 124. The encapsulated packlet group 124 is flipped over to permit further processing in connection with completing manufacture of the SiP.

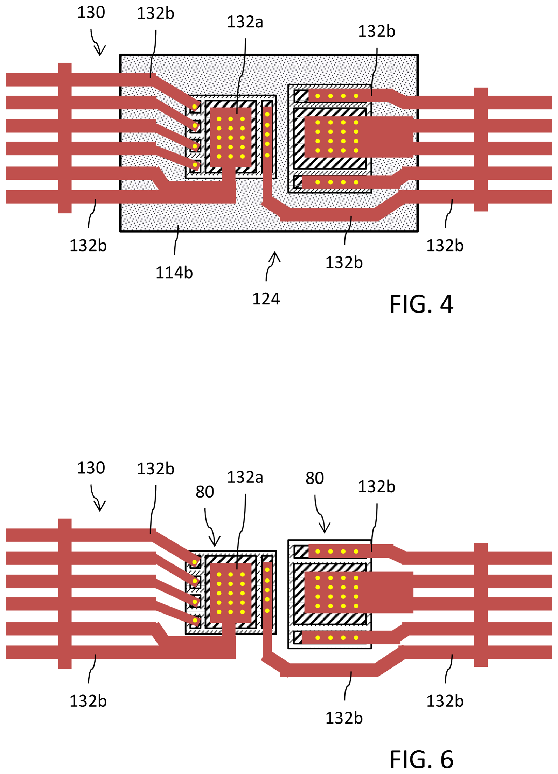

Figure 3H - a premanufactured leadframe 130 for the SiP is then attached to the metal die pads 32a (if present) and metal leads 32b of the IC packlets 80 within the encapsulated packlet group 124. This leadframe 130 includes a diepad 132a to be mounted to each included metal die pad 32a and a plurality of leads 132b having proximal ends mounted to the metal leads 32b (and perhaps being extensions from the diepads 132a). The attachment of the diepad 132a proximal ends of the leads 132b to the metal die pads 32a and metal leads 32b of the IC packlets 80 may be accomplished by one of: laser bonding, ultrasonic bonding, solder paste and reflow, or copper based sintering (schematically indicated by the dots in Figure 4).

Figure 4 shows a bottom view of an example leadframe 130 for the SiP attached to the metal die pads 32a and metal leads 32b of the IC packlets 80 within the encapsulated packlet group 124. It will be noted that the distal ends of the leads 132b extend outwardly beyond the outer peripheral edge of the encapsulating body 114b. It will further be noted that the distal ends of the leads 132b are connected by tie bar structures which will be removed in a subsequent process step.

Figure 3I - a heatsink 140, for example made of a copper material (slug or plate), is the attached at the leadframe 130 side of the encapsulated packlet group 124 using a non-electrically conductive adhesive layer 142 having a high thermal conductivity using ceramic-based fillers for instance (for example, made of aluminum oxide (Al₂O₃), aluminum nitride (AlN) or silicon nitride (SiN)).

Figure 3J - an optional molding process may then be performed to provide an insulating lateral encapsulation 150 of the heatsink 140 and the non-electrically conductive adhesive layer 142. The leadframe 130 can be severed, if necessary.

The manufacture of the SiP is now completed.

The distal ends of the leads 132b which extend outwardly beyond the outer peripheral edge of the encapsulating body 114b may be bent in an L or Z shape, as needed, to support mounting of the SiP to a support such as a printed circuit board (PCB).

Reference is now made to Figures 5A-5G which show steps in a process for manufacturing a system in package (SiP) which includes a plurality of IC packlets 80. The packlets 80 may be made using the process of Figures 1A-1K. The IC packlets 80 to be included in the SiP perform different functionalities. For example, the SiP may include: an IC packlet 80cpu which includes an encapsulated bare integrated circuit die 10cpu configured to perform processing functionalities; an IC packlet 80mem which includes an encapsulated bare integrated circuit die 10mem configured to perform data storage (memory) functionalities; and an IC packlet 80io which includes an encapsulated bare integrated circuit die 10io configured to perform communication (input/output) functionalities. It will be understood that the illustrated inclusion of packlets 80 for processing, memory and communication functionalities is just an example, without limitation, of what may be included in the SiP.

Figure 5A - a premanufactured leadframe 130 for the SiP is provided. The leadframe 130 includes a plurality of diepads 132a and a plurality of leads 132b. One or more leads 132b may comprise extensions from a diepad 132a. Groups 100 of IC packlets 80 for each SiP are mounted adjacent each other to the leadframe 130. The illustration of this figure shows all the packlets 80 of one group 100 as well as a portion of the packlet 80 within each of the groups 100 adjacent (to the left and right) thereto. It will be understood that more than three groups 100 may be mounted to the leadframe 130 for common processing. As an example, each of the groups 100 includes the IC packlets 80cpu, 80mem, 80io for the SiP.

The metal die pads 32a (if present) and metal leads 32b of each IC packlet 80 are attached to the leadframe. Specifically, each included metal die pad 32a is mounted to a corresponding diepad 132a of the leadframe 130 and each metal lead 32b is mounted to a corresponding leads 132b of the leadframe 130. The attachments between corresponding metal die pads 32a of the IC packlets 80 and diepads 132a of the leadframe 130 and between corresponding metal leads 32b of the IC packlets 80 the proximal ends of the leads 132b of the leadframe 130 may be accomplished by one of: laser bonding, ultrasonic bonding, solder paste and reflow, or copper based sintering (schematically indicated by the dots in Figure 6).

Figure 6 shows a bottom view of an example leadframe 130 for the SiP attached to the metal die pads 32a and metal leads 32b of the IC packlets 80. It will be noted that the distal ends of the leads 132b are connected by tie bar structures which will be removed in a subsequent process step.

Figure 5B - a heatsink 140, for example made of a copper material (slug or plate), is the attached at the leadframe 130 side of the SiP using a non-electrically conductive adhesive layer 142 with a high thermal conductivity using ceramic-based fillers for instance (for example, made of aluminum oxide (Al₂O₃), aluminum nitride (AlN) or silicon nitride (SiN)). As an example, one heatsink 140 may be provided for each group 100 of IC packlets 80.

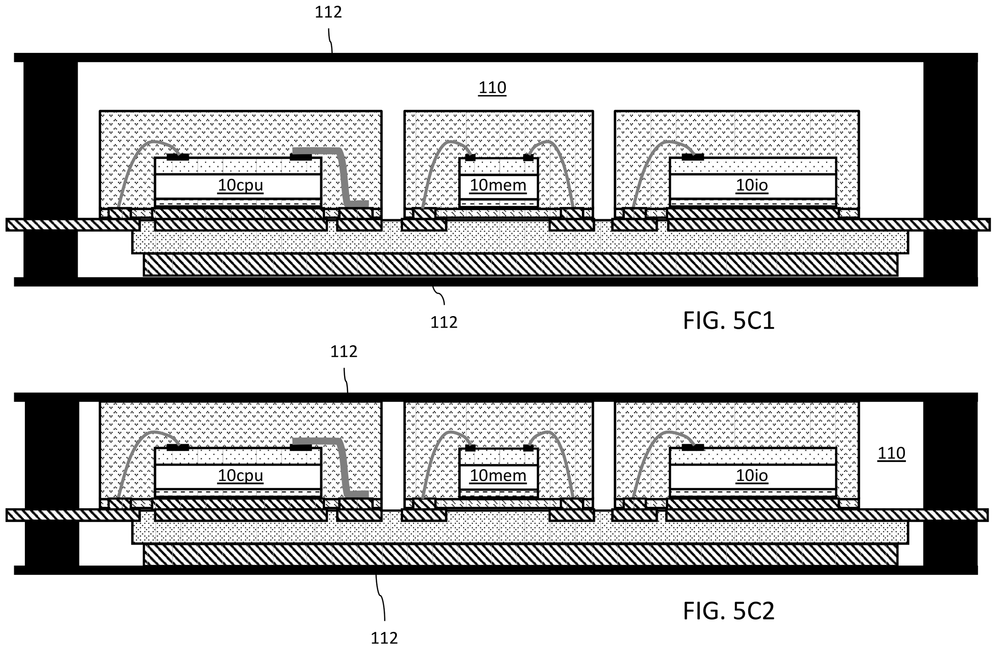

Figures 5C1, 5C2 - the leadframe 130 with the mounted groups 100 of IC packlets 80 is then placed with a cavity 110 of a two-part mold 112. The two-part mold 112 of Figure 5C1 differs from the two-part mold 112 of Figure 5C2 only in terms of the size of the cavity 110. In Figure 5C1, the two-part mold 112 defines a cavity 110 with a depth larger than a thickness of the IC packlets 80, leadframe 130, layer 142 and heatsink 140. In Figure 5C2, the two-part mold 112 defines a cavity 110 with a depth equal to a thickness of the IC packlets 80, leadframe 130, layer 142 and heatsink 140. It will be noted that the two halves of the mold 112 include mold structures for clamping the distal ends of the leads 132b (for example, at or about the location of the tie bar structures).

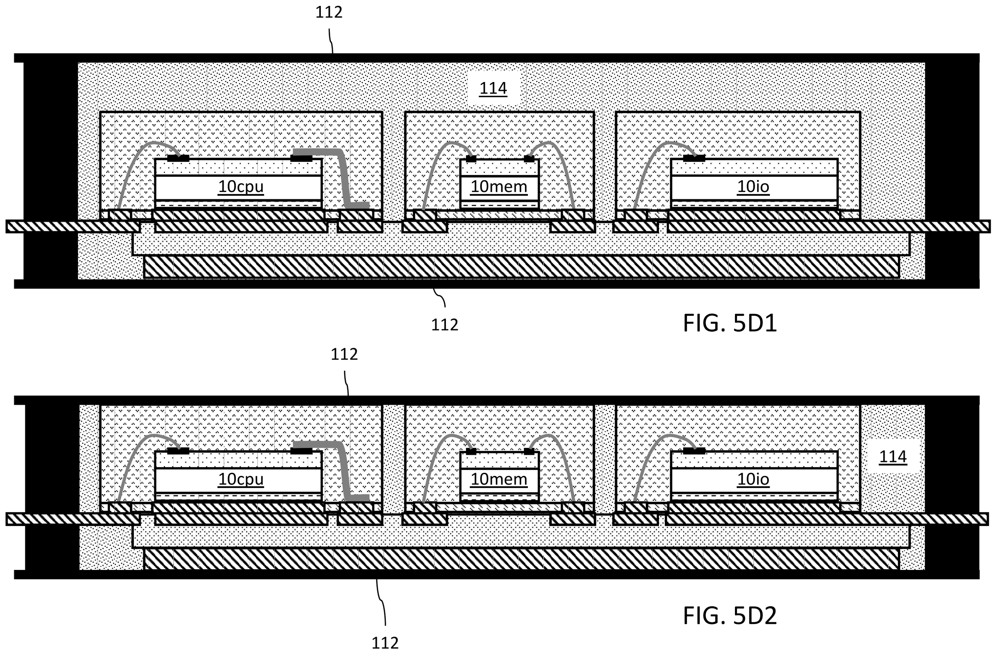

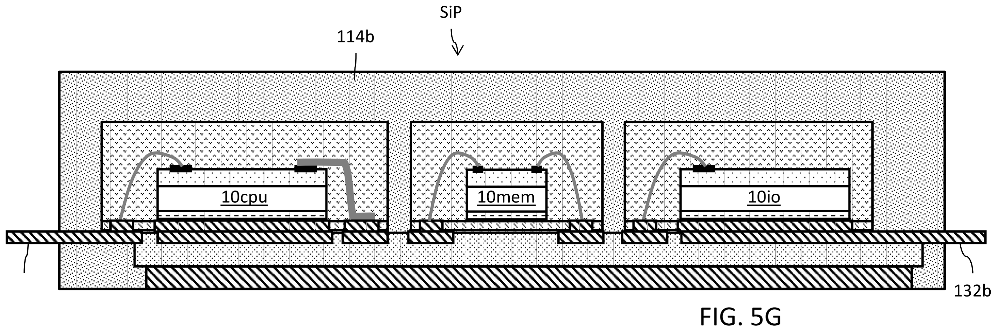

Figures 5D1, 5D2 - an encapsulation material 114 is injected into the cavity 110 and allowed to cure so as to laterally encapsulate each of the groups 100 of IC packlets 80. This encapsulation material 114 provides an encapsulating body 114b (Figure 5G) of each SiP (Figure 5G).

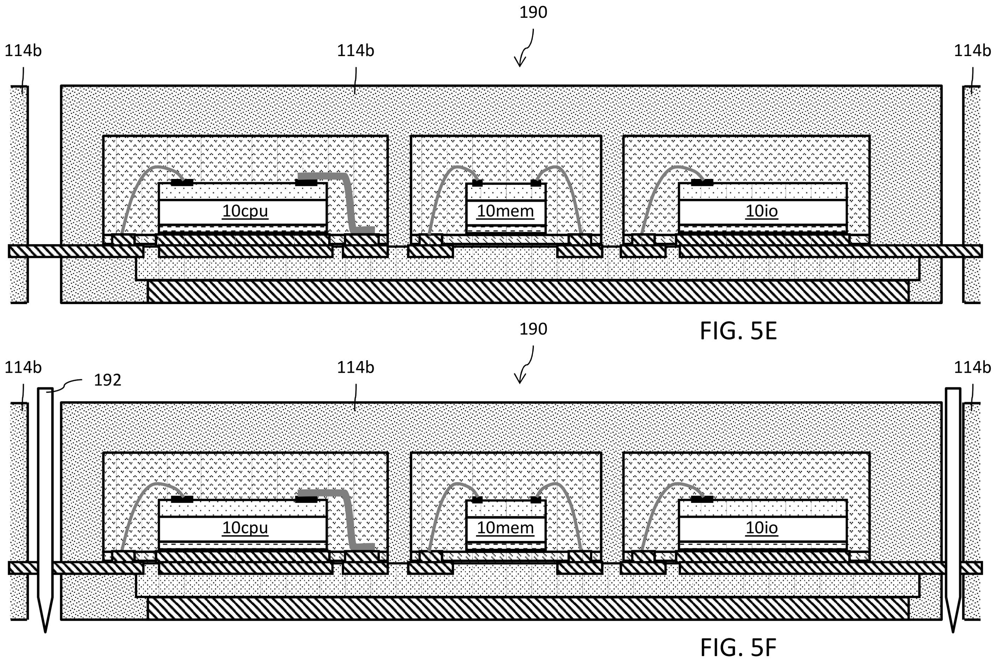

Figure 5E - the encapsulated groups 100 of IC packlets 80 mounted to the leadframe 130 are removed from the mold 112 to form a group 190 of SiPs mounted to the leadframe 130. It will be noted here that the illustration shows the group 190 produced by the molding operations of Figures 5B1 and 5C1 where portions of the encapsulation material 114 cover the upper surfaces of the included IC packlets 80. The group 190 produced by the molding operations of Figures 5D2 and 5D2 would look the same except that the upper surface of the encapsulation material 114 would be coplanar with the upper surfaces of the included IC packlets 80. The remainder of the description for the process of manufacturing the SiP will refer to the group 190 shown in Figure 5E, but it will be understood that the steps in the process are equally applicable to group 190 produced by the molding operations of Figures 5D2 and 5D2.

Figure 5F - the group 190 is then processed in a singulation operation by cutting 192 through the distal ends of the leads 132b between SiPs (and removing the tie bar structures) to produce a plurality of individual SiPs (one such SiP shown in Figure 5G). The cutting may be performed by a sawing action taken between the encapsulating bodies 114b of adjacent SiPs in the chain 190.

The manufacture of the SiP is now completed.

It will be noted that the distal ends of the leads 132b which extend outwardly beyond the outer peripheral edge of the encapsulating body 114b may be bent in an L or Z shape, as needed, to support mounting of the SiP to a support such as a printed circuit board (PCB). This lead bending operation may, for example, be performed prior to singulation (i.e., before the step shown in Figure 5F.

The choice of using one or the other of the manufacturing processes of Figures 3 and 5 may, for example, depend on the quality of the material being and the difficulty of ensuring alignment. Additionally, the availability of certain types of equipment and the relative cost can have an effect on manufacturing process choice. Still further, the interconnection being used to connect the packlets to the leadframe can drive selection between the manufacturing processes.

An advantage of the SiP manufacturing processes using packlets 80 is that a high cost direct copper bond (DCB) on ceramic substrate or active metal brazed (AMB) on ceramic substrate is not used. However, the use of heatsink 140 with non-electrically conductive (for example, ceramic-base filler material) adhesive layer 142 provides effective and efficient thermal performance.

While the invention has been illustrated and described in detail in the drawings and foregoing description, such illustration and description are considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims.

## Claims

1. A method, comprising:
mounting a plurality of bare integrated circuit (IC) dies rear face down to a metal plate;
connecting electrical interconnections between connection pads at front faces of the plurality of bare IC dies and connection regions of the metal plate;
placing the metal plate with the plurality of bare IC dies and electrical interconnections in a first mold cavity;
injecting an encapsulation material into the first mold cavity to encapsulate the plurality of bare IC dies and electrical interconnections within a first encapsulating body and form a panel;
etching the metal plate to form individual metal leads at the connection regions; and
cutting through the first encapsulating body at locations between adjacent IC dies to singulate the panel into a plurality of packlets.

2. The method of claim 1, wherein etching the metal plate further forms individual die pads at the locations of the plurality of bare IC dies.

3. The method of claim 1 or 2, further comprising, before cutting, performing electrical testing of the plurality of bare IC dies, the electrical interconnections and the individual metal leads by contacting test probes to the individual metal leads.

4. The method of any one of claims 1 to 3, further comprising, after etching, forming an insulating layer at a backside of the first encapsulating body between the individual metal leads.

5. The method of any one of claims 1 to 4, wherein the plurality of bare IC dies are configured to perform a same functionality, and steps of the method of claim 1 are repeated with bare IC dies having different functionalities to produce packlets having different functionalities.

6. The method of claim 5, further comprising:
mounting a group of packlets to a carrier tape, wherein said group of packlets includes a first packlet having a first functionality and a second packlet having a second functionality;
placing the carrier tape with the group of packlets in a second mold cavity;
injecting an encapsulation material into the second mold cavity to encapsulate the group of packlets within a second encapsulating body to form an encapsulated packlet group;
removing the carrier tape;
attaching the encapsulated packlet group to a leadframe, wherein the individual metal leads of the first and second packlets having the first and second functionalities, respectively, of the encapsulated packlet group are mounted to corresponding leadframe leads of the leadframe; and
mounting a heatsink using a non-electrically conductive adhesive material to the leadframe opposite the group of packlets to form a system in package (SiP).

7. The method of claim 6, further comprising cutting through the second encapsulating body to define sides of the encapsulated packlet group.

8. The method of claim 6 or 7, further comprising encapsulating the heatsink and non-electrically conductive adhesive material within a third encapsulating body.

9. The method of claim 8, wherein distal ends of the leadframe leads extend out from the sides of the third encapsulating body.

10. The method of claim 5, further comprising:
mounting a group of packlets to a leadframe, wherein the group of packlets includes a first packlet having a first functionality and a second packlet having a second functionality connected to a plurality of leadframe leads of the leadframe;
mounting a heatsink using a non-electrically conductive adhesive material to the leadframe opposite the group of packlets;
placing the leadframe with the group of packlets and the adhesively mounted heatsink in a second mold cavity; and
injecting an encapsulation material into the second mold cavity to encapsulate the group of packlets and adhesively mounted heatsink within a second encapsulating body to form a system in package (SiP).

11. The method of any one of claims 6 to 10, wherein a side of each packlet having the individual metal leads is mounted to the carrier tape or to the leadframe and wherein an opposite side of each packlet is in contact with a mold defining the second mold cavity or is offset from a mold defining the second mold cavity.

12. The method of claim 10 or 11, further comprising cutting through distal ends of the leadframe leads.

13. The method of any one of claims 10 to 12, wherein the mold defining the second mold cavity defines sides of the SiP.

14. The method of claim 13, wherein cut ends of the leadframe leads extend out from the sides of the SiP.

15. The method of any one of claims 6 to 14, wherein the non-electrically conductive adhesive material comprises an adhesive including ceramic-based fillers.
